# EUROPEAN PATENT SPECIFICATION

(11) **EP 3 364 476 B1**
(45) Date of publication and mention of the grant of the patent: **05.06.2024**
(21) Application number: 17156902.3
(22) Date of filing: 20.02.2017
(51) Int. Cl.: H10K 50/155, H10K 59/35, H10K 85/30

(54) **ACTIVE OLED DISPLAY, METHOD FOR PREPARING AN ACTIVE OLED DISPLAY AND COMPOUND**
AKTIVE OLED-ANZEIGE, VERFAHREN ZUR HERSTELLUNG EINER AKTIVEN OLED-ANZEIGE UND VERBINDUNG
ÉCRAN DELO ACTIF, PROCÉDÉ DE PRÉPARATION D'UN ÉCRAN DELO ACTIF ET COMPOSÉ

(43) Date of publication of application: 22.08.2018
(73) Proprietor: Novaled GmbH, 01099 Dresden (DE)
(72) Inventor: HEGGEMANN, Ulrich, 01307 Dresden (DE); HUMMERT, Markus Dr., 01307 Dresden (DE)
(74) Representative: Bittner, Thomas L.

(56) References cited:
- EP-A1- 0 510 541
- EP-A1- 3 002 797
- EP-A1- 3 133 663
- EP-A1- 3 133 664
- WO-A1-2017/014946
- JP-A- 2010 087 276
- US-A1- 2013 330 632
- US-A1- 2014 264 295
- SLAWOMIR PITULA ET AL: "Synthesis, Structure, and Physico-optical Properties of Manganate(II)-Based Ionic Liquids", CHEMISTRY - A EUROPEAN JOURNAL, vol. 16, no. 11, 15 March 2010 (2010-03-15), pages 3355-3365, XP055358644, ISSN: 0947-6539, DOI: 10.1002/chem.200802660

## Description

The disclosure relates to an active OLED display having a plurality of OLED pixels and comprising a non-oxidizing p-dopant in a hole injection and/or hole transport layer shared by at least two pixels, a method of preparing the active OLED display and to a compound particularly suitable for the display.

### Background

With respect to active OLED displays, comprising a plurality of OLED pixels sharing a common hole transport layer, challenging requirements are put on semiconducting materials used in layers arranged between the anode and the emitting layer and shared by the plurality of pixels. On one hand, the materials shall enable individual driving of individual pixels at operational voltages which are as low as possible. On the other hand, so called electrical crosstalk between neighbour pixels should be avoided. The application WO2016/050834 teaches that these contradictory requirements can be fulfilled by p-doped layers having electrical conductivity in the range 1×10⁻³ S·m⁻¹ and 1×10⁻⁸ S·m⁻¹, most favourably between 1×10⁻⁵ S·m⁻¹ and 1×10⁻⁶ S·m⁻¹. Such low-conductivity p-doped hole transport layers are achievable by use of usual state-of-art redox dopants, like strongly electron accepting radialene compounds, in matrices which are poorly dopable in terms of their deep HOMO level. Document US2014/264295 A1 discloses an OLED display having a conventional p-dopant in its hole transport layer, while documents WO2017/014946 A1, US2013/330632 A1 and EP0510541 A1 disclose metal salts used as p-dopants in OLED devices. Different metal salts are also disclosed in Slawomir, P. et al. in Chemistry- A European Journal, vol. 16, no. 11, page 3355-3365, and EP1209708. JP2010/087276 A discloses an OLED display comprising a common hole transporting layer shared by a plurality of pixels and containing a metal salt or an organic salt. There is, however, continuing demand for p-dopants fulfilling these criteria and improved in other parameters, e.g. from the viewpoint of processability and device stability.

### Summary

It is an object to provide improved active OLED displays and improved materials enabling this improvement. In one aspect, electrical crosstalk between neighbor pixels of the active OLED display shall be reduced. In another aspect, the improved materials should enable robust display manufacturing, e.g. in terms of improved device stability during any processing step which comprises a treatment of the device or its particular layer at an elevated temperature.

The object is achieved through a display device comprising
- a plurality of OLED pixels comprising at least two OLED pixels, the OLED pixels comprising an anode, a cathode, and a stack of organic layers, wherein the stack of organic layers
- is arranged between and in contact with the cathode and the anode, and
- comprises a first electron transport layer, a first hole transport layer, and a first light emitting layer provided between the first hole transport layer and the first electron transport layer, and
- a driving circuit configured to separately driving the pixels of the plurality of OLED pixels,
   wherein, for the plurality of OLED pixels, the first hole transport layer is provided in the stack of organic layers as a common hole transport layer shared by the plurality of OLED pixels, and the first hole transport layer comprises
      (i) at least one first hole transport matrix compound consisting of covalently bound atoms and
      (ii) at least one electrical p-dopant selected from metal salts and from electrically neutral metal complexes comprising a metal cation and at least one anion and/or at least one anionic ligand, wherein the anion and/or the anionic ligand consists of at least 5 covalently bound atoms, wherein the anion and/or anionic ligand comprises at least one atom selected from B, C, N,
   wherein the metal cation of the electrical p-dopant is selected from alkali metals; alkaline earth metals, Pb, Mn, Fe, Co, Ni, Zn, Cd; rare earth metals in oxidation state (II) or (III); Al, Ga, In; and from Sn, Ti, Zr, Hf, V, Nb, Ta, Cr, Mo and W in oxidation state (IV) or less.

In one embodiment, the anion and/or the anionic ligand is bound to the metal cation of the p-dopant through an oxygen atom, preferably through two oxygen atoms.

It is to be understood that the term "bound" encompasses structures of the p-dopant, wherein the distance between the metal cation and the oxygen atom/atoms is shorter that the distance between the metal cation and any other atom of the anion and/or of the anionic ligand.

In an embodiment, not forming part of the claimed invention, the oxygen atom of the anion and/or of the anionic ligand which is in the metal salt and/or in the metal complex bound to the metal cation has in dichloroethane lower basicity than at least one non-oxygen atoms of the anion and/or of the anionic ligand.

Analogously, in another embodiment, not forming part of the claimed invention, each of the oxygen atoms of the anion and/or of the anionic ligand which are in the metal salt and/or in the metal complex bound to the metal cation has in dichloroethane lower basicity than at least one non-oxygen atom of the anion and/or of the anionic ligand.It is to be understood that the basicity of an atom in the anion and/or in the anionic ligand in an environment, e.g. in 1,2-dichloroethane, is inversely proportional to the acidity of a corresponding tautomeric form of the electrically neutral conjugated acid formed by addition of one or more protons in the same environment. Measurement of the acidity in 1,2-dichloroethane as a versatile tool for comparison of various acids is described in Journal of Organic Chemistry (2011), 76(2), 391-395. It is understood that if the basicity of a particular atom in an anion and/or anionic ligand has to be assessed, the "corresponding tautomeric form" of the electrically neutral conjugated acid is the acid formed by proton addition to the particular atom.

In one embodiment,_the anion and/or the anionic ligand consists of at least 6, more preferably at least 7, even more preferably at least 8, most preferably at least 9 covalently bound atoms.

In one embodiment,_the anion and/or the anionic ligand comprises at least two atoms selected from B, C and N which are bound to each other by a covalent bond.

In one embodiment,_the anion and/or the anionic ligand comprises at least one peripheral atom selected from H, N, O, F, Cl, Br and I. Under "peripheral atom", it is to be understood an atom which is covalently bound to only one atom of the anion and/or of the anionic ligand. Oppositely, atoms covalently bound to at least two other atoms of the anion and/or of the anionic ligand are assigned as inner atoms.

Under covalent bond, it is to be understood any bonding interaction which involves electron density sharing between the two assessed atoms, wherein the bonding is stronger than van der Waals dispersive interactions; for the sake of simplicity, binding energy 10 kJ/mol may be taken as an arbitrary lower limit. In this sense, the term includes also coordination bonds or hydrogen bonds. Anions and/or anionic ligands comprising hydrogen bonds, however, are not particularly preferred.

In one embodiment, the anion and/or the anionic ligand comprises at least one electron withdrawing group selected from halogenated alkyl, halogenated (hetero)aryl, halogenated (hetero)arylalkyl, halogenated alkylsulfonyl, halogenated (hetero)arylsulfonyl, halogenated (hetero)arylalkylsulfonyl, cyano. It is to be understood that for the sake of brevity, halogenated (hetero)aryl means "halogenated aryl or halogenated heteroaryl", halogenated (hetero)arylalkyl means "halogenated heteroarylalkyl or halogenated arylalkyl", halogenated (hetero)arylsulfonyl means "halogenated heteroarylsulfonyl or halogenated arylsulfonyl" and halogenated (hetero)arylalkylsulfonyl means "halogenated heteroarylalkylsulfonyl or halogenated arylalkylsulfonyl".

In one embodiment, the electron withdrawing group is a perhalogenated group. It is to be understood that the term "halogenated" means that at least one hydrogen atom of a group comprising peripheral or inner hydrogen atoms is replaced with an atom selected from F, Cl, Br and I. It is further understood that in a perhalogenated group, all hydrogen atoms comprised in the unsubstituted group are replaced with atoms independently selected from F, Cl, Br and I. Accordingly, under perfluorinated group, it is to be understood a perhalogenated group, wherein all halogen atoms replacing hydrogen atoms are fluorine atoms.

In one embodiment, the metal cation of the p-dopant is selected from Li(I), Na(I), K(I), Rb(I), Cs(I); Mg(II), Ca(II), Sr(II), Ba(II), Sn(II), Pb(II), Mn(II), Fe(II), Co(II), Ni(II), Zn(II), Cd(II), Al(III); rare earth metal in oxidation state (III), V(III), Nb(III), Ta(III), Cr(III), Mo(III), W(III) Ga(III), In(III) and from Ti(IV), Zr(IV), Hf(IV), Sn(IV).

In one embodiment, in the p-dopant molecule, the atom of the anion and/or of the anionic ligand which is closest to the metal cation is a C or a N atom.

In one embodiment, the acidity of the electrically neutral conjugated acid formed from the anion and/or anionic ligand by addition of one or more protons in 1,2-dichloroethane is higher than that of HCl, preferably higher than that of HBr, more preferably higher than that of HI, even more preferably higher than that of fluorosulfuric acid, and most preferably higher than that of perchloric acid.

In one embodiment, the electrical p-dopant has energy level of its highest unoccupied molecular orbital computed by standard quantum chemical method and expressed in absolute vacuum scale at least 0.5 eV, preferably at least 0.6 eV, more preferably at least 0.8 eV, even more preferably at least 1.0 eV, most preferably at least 1.2 eV above the energy level of the highest occupied orbital of the covalent hole transport compound computed by the standard quantum chemical method.

The standard quantum chemical method may be the software package TURBOMOLE using DFT functional B3LYP with the basis set def2-TZVP.

In one embodiment, the first hole transport matrix compound is an organic compound, preferably an organic compound comprising a conjugated system of at least 6, more preferably at least 10 delocalized electrons; also preferably, the first hole transport matrix compound comprises at least one triaryl amine structural moiety, more preferably, the first hole transport matrix compound comprises at least two triaryl amine structural moieties.

The object is further achieved by method for preparing the display device according to any of the preceding embodiments, the method comprising at least one step wherein the hole transport matrix compound and the electrical p-dopant are in mutual contact exposed to a temperature above 50 °C.

In one embodiment, the method may comprise the steps, wherein
(i) the p-dopant and the first hole transport matrix compound are dispersed in a solvent,
(ii) the dispersion is deposited on a substrate and
(iii) the solvent is evaporated at an elevated temperature.

The method may further comprise at least one step wherein the p-dopant is evaporated at a reduced pressure, preferably at a pressure below 1×10⁻² Pa and at a temperature above 50 °C, more preferably at a pressure below 5×10⁻² Pa and at a temperature above 80 °C, even more preferably at a pressure below 1×10⁻³ Pa and at a temperature above 120 °C, most preferably at a pressure below 5×10⁻⁴ Pa and at a temperature above 150 °C.

In one embodiment, the p-dopant may be used in form of a solid hydrate.

In another embodiment, the p-dopant may be used as an anhydrous solid comprising less than 0.10 wt% water, preferably less than 0.05 wt% water.

The object is further achieved by compound having formula (I) 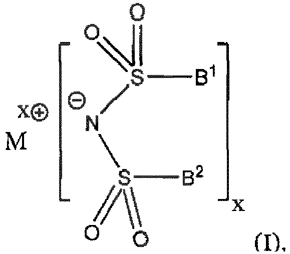 wherein
M^{x⊕} is a x-valent cation of a metal selected from alkali metals, alkaline earth metals, rare earth metals and Al, Ga, In, Sn, Pb, Ti, Zr, Hf, V, Nb, Ta, Cr, Mo, W, Mn, Fe, Co, Ni, Zn and Cd;
x is 1 for M selected from alkali metals; 2 for M selected from alkaline earth metals, Mn, Fe, Co, Ni, Zn and Cd; 2 or 3 for M selected from rare earth metals; 3 for Al, Ga, In; 2, 3 or 4 for Ti, Zr, Hf, V, Nb, Ta, Cr, Mo, W; and 2 or 4 for Sn;
B¹and B² is independently selected from perhalogenated C₃ to C₂₀ alkyl, C₃ to C₂₀ cycloalkyl or C₃ to C₂₀ arylalkyl;
with the proviso that the compound having formula (I), wherein
   a) M is selected from alkali metals, Mg, Ca and Zn and B¹ and B² are independently selected from perfluorinated straight-chain primary alkyl, or
   b) M is Li and B¹and B² is perfluorinated isopropyl,
   is excluded.

In one embodiment, M is selected from Mg(II), Mn(II) and Zn(II).

In one embodiment, the compound according to formula (I) is provided in a solid form, preferably in a solid form comprising less than 0.10 wt % water, more preferably in a solid form comprising less than 0.05 wt % water, most preferably in a solid crystalline form comprising less than 0.05 wt % water.

In another embodiment, the compound according to formula (I) is provided in form of a solid crystalline hydrate, preferably in form of a solid crystalline hydrate which has water content in the range
(i) from 30.33 to 36.33 mol%, preferably from 31.00 to 35.66 mol%, more preferably from 31.00 to 35.66 mol%, even more preferably from 31.66 to 35.00 mol%, even more preferably from 32.33 to 34.33 mol%, most preferably from 33.00 to 33.66 mol%; or
(ii) from 18.20 to 21.80 mol%, preferably from 18.60 to 21.40 mol%, more preferably from 19.00 to 21.00 mol%, even more preferably from 19.40 to 20.60 mol%, most preferably from 19.80 to 20.20 mol%.

### Effect of the invention

An important property of materials comprised in organic semi-conducting devices is their conductivity. In a display device having a structured anode and at least two pixels sharing at least one hole transport and/or hole injection layer, as described in WO2016/050834, a limited conductivity of the shared layer may be favourable for achieving a low level of the undesired electrical crosstalk in the display. On the other hand, very low conductivity of the shared layer may increase the operational voltage of the display. WO2016/050834 teaches a conductivity range which represents a trade-off between these contradictory requirements.

The authors of the present application, however, surprisingly found that electrical p-dopants based on certain metal salts and metal complexes enable, under certain conditions, preparing p-doped materials and/or p-doped layers providing stable hole injection state-of-art anodes into state-of-art hole transport matrices, without substantially increasing the concentration of the free charge carriers above the level which corresponds to conductivities observed in a neat matrix.

This surprising finding offered an opportunity to build the displays of WO2016/050834, operating at fully comparable voltages, even though the hole transport and/or hole injection layers shared by the multiplicity of pixels have conductivities below the optimum range between 1×10⁻⁵ S·m⁻¹ and 1×10⁻⁶ S·m⁻¹ as disclosed in WO2016/050834. The dopants of the present application enable efficient operation of display devices of WO2016/050834 at the level of electrical conductivity in p-doped layers shared by the multiplicity of pixels which is near to the detection limit of the available measuring procedure or below it. Thus, the dopants of the present application enable further suppressing the electrical crosstalk in OLED displays and offer new opportunities for designing efficient OLED displays exhibiting very low level of electrical crosstalk. These observations made by the authors will be further described in more detail.

In a previous application EP15181385 filed by the applicant, some of the authors described successful use of some metal amides like 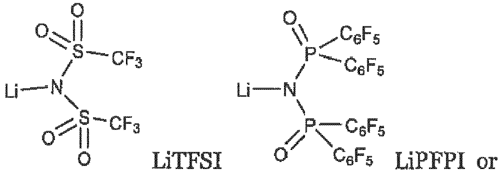 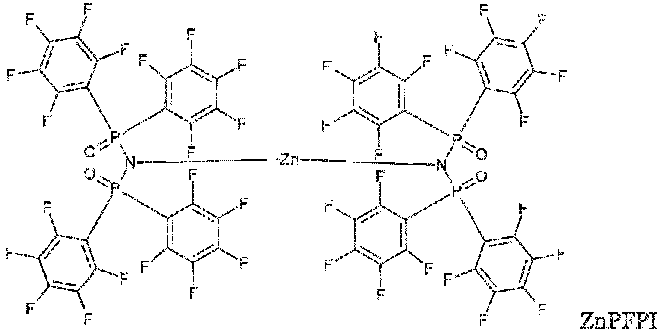 as hole injection materials in organic electronic devices.

Parallel with further investigation of analogous metal amide compounds, the authors surprisingly found that also some structurally quite different compounds, namely metal borate complexes like 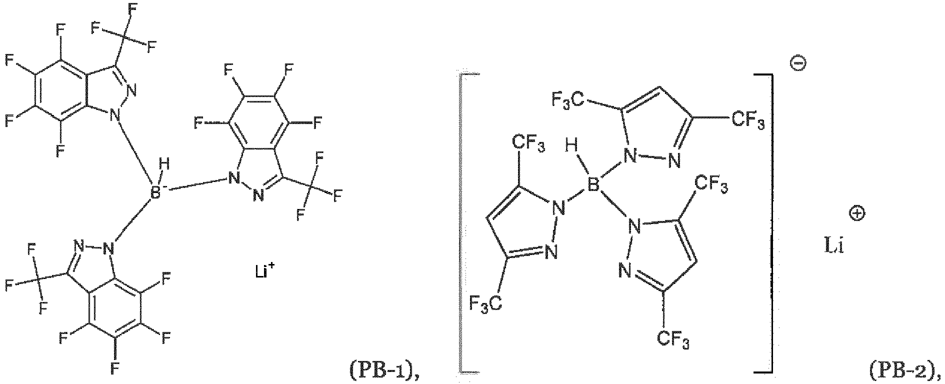 are utilizable in an analogous way.

Most surprisingly, the authors found that all these structurally different compounds analogously exhibit two different modes in their p-doping activity, depending on the process conditions during preparation of the doped material and/or layer.

In the first mode, semiconducting materials and/or layers doped with these compounds (which can be generalized as metal salts and/or electrically neutral metal complexes with an anionic ligand) exhibit well-measurable electrical conductivities which are only slightly lower in comparison with materials and/or layers doped with typical redox p-dopants. It appears that this mode occurs if the doped material and/or layer is exposed to oxygen, even though only in trace amounts.

In the second mode, the semiconducting materials and/or layers doped with the disclosed metal salts and/or electrically neutral metal complexes comprising an anionic ligand exhibit hardly measurable electrical conductivities. This mode occurs if the oxygen access to the doped material and/or layer is strictly avoided throughout processing thereof. The authors found that despite the extremely low conductivity of materials and/or layers doped in the second mode, devices comprising such materials and/or layers particularly as hole transporting or hole injecting layers still exhibit electrical behavior corresponding to an excellent hole injection.

The existence of the two above described modes of p-doping activity provides the disclosed p-dopants with a unique versatility in their use in organic electronic devices, and particularly in displays comprising an anode structured into a multiplicity of pixels sharing a common hole transport layer. The conductivity of the common p-doped layer can be either set in the limits taught in WO2016/050834 by exploiting the first doping mode, or set below these limits, exploiting the second doping mode.

Furthermore, recent investigations made by the authors provided hints that the materials and/or layers doped with the presented metal salts and/or metal complexes may exhibit favourable thermal stability, particularly in materials provided according to the above described second mode of the p-doping action. These properties may be again particularly suitable for the use of the disclosed p-dopants in AMOLED displays, because the necessity of structuring such displays into separate pixels often requires a thermal treatment of p-doped layers or using another treatment which may result in an unavoidable heating of a previously deposited p-doped layer.

In a specific embodiment of the invention, the authors provided new amide compounds comprising bulkier fluorinated side chains in comparison with the compounds tested in EP15181385. This change resulted in favourable storage properties of the new compounds, which are substantially non-hygroscopic and remain solid even at high air humidity, whereas LiTFSI and analogous TFSI salts have tendency to deliquesce.

### Detailed description

The electrical conductivity of a thin layer sample can be measured by, for example, the so called two-point method. At this, a voltage is applied to the thin layer and the current flowing through the layer is measured. The resistance, respectively the electrical conductivity, results by considering the geometry of the contacts and the thickness of the layer of the sample. The experimental setup for conductivity measurement used by the authors of the present application enables deposition of p-doped layers as well as conductivity measurement under controlled conditions, especially with regard to contact of deposited layers with an atmosphere comprising oxygen. In this regard, the whole deposition-measurement sequence may be carried out either in a glove-box or in a chamber comprising a controlled atmosphere, using solution processing techniques, or completely in a vacuum chamber, using vacuum thermal evaporation (VTE) as the method of choice, especially suitable for materials and/or layers doped in the second mode.

I The electrical conductivity of the first hole transport layer may be lower than 1×10⁻⁶ S·m⁻¹, preferably lower than 1×10⁻⁷ S·m⁻¹, more preferably lower than 1×10⁻⁸ S·m⁻¹. Alternatively, provided that the detection limit of the used conductivity measurement method is lower than 1×10⁻⁶ S·m⁻¹, it is preferred that the conductivity of the first hole transport layer is lower than the detection limit.

The first hole transport layer (HTL) is formed for the plurality of OLED pixels in the OLED display. In the claimed invention, the first HTL extends over all pixels of the plurality of pixels in the OLED display. Similarly, the cathode may be formed as a common cathode for the plurality of pixels. The common cathode may extend over all pixels of the plurality of pixels in the OLED display. Every individual pixel may have its own anode that may not touch anodes of other individual pixels.

Optionally, for one or more of the plurality of OLED pixels, following organic layers may be provided: a hole blocking layer, an electron injection layer, and/or an electron blocking layer.

Further, the active OLED display has driving circuit configured to separately drive the individual pixels of the plurality of pixels provided in the OLED display. In one embodiment, a step of separately driving may comprise separate control of the driving current applied the individual pixels.

The first HTL is made of a hole transport matrix (HTM) material electrically doped with the p-dopant. The hole transport matrix material may be electrically doped with more than one p-dopant. It is to be understood that the HTM material may consist of one or more HTM compounds, whereas the term hole transport material is a broader term used throughout this application for all semiconducting materials comprising at least one hole transport matrix compound. The hole transport matrix material is not particularly limited. Generally, it is any material consisting of covalently bound atoms which allows embedding the p-dopant. In this sense, infinite inorganic crystals having predominantly covalent bonds like silicon or germanium, or extremely crosslinked inorganic glasses like silicate glass, do not fall in the scope of the definition of the hole transport matrix material. Preferably, the hole transport matrix material may consist of one or more organic compounds.

The first hole transport layer may have a thickness of less than 50 nm, less than 40 nm, less than 30 nm, less than 20 nm, or less than 15 nm.

The first hole transport layer may have a thickness of more than 3 nm, more than 5 nm, more than 8 nm, or more than 10 nm.

The anode may be made of a transparent conductive oxide (TCO), like indium tin oxide (ITO) or aluminium zinc oxide (AZO). Alternatively, the anode may be made of one or more thin metallic layers leading to a semitransparent anode. In another embodiment, the anode may be made of a thick metallic layer which is not transparent to visible light.

The OLED pixel(s) may comprise an electron blocking layer (EBL) provided between the first hole transport layer and the light emitting layer. The EBL may be in direct contact with the first HTL and the EML. The electron blocking layer may be an electrically undoped layer (in other words, it may be free of an electrical dopant) made of an organic hole transport matrix material. The composition of the organic hole transport matrix material of the first hole transport layer may be the same as the composition of the organic hole transport matrix material of the electron blocking layer. In another embodiment of the invention, the composition of both hole transport matrix materials may be different.

The EBL may have a layer thickness of more than 30 nm, more than 50 nm, more than 70 nm, more than 100 nm, or more than 110 nm.

The thickness of the EBL may be less than 200 nm, less than 170 nm, less than 140 nm, or less than 130 nm. Compared to the EBL, the common HTL may be thinner by about one order of magnitude.

Each compound forming the electron blocking layer may have a highest occupied molecular orbital (HOMO) energy level, expressed in the absolute scale referring to vacuum energy level being zero, higher than a HOMO level of any compound forming the hole transport matrix material of the common hole transport layer.

The organic matrix material of the electron blocking layer may have a hole mobility which is equal to or higher than the hole mobility of the matrix material of the hole transport layer.

The hole transport matrix (HTM) material of the common HTL and/or of the EBL may be selected from compounds comprising a conjugated system of delocalized electrons, the conjugated system comprising lone electron pairs of at least two tertiary amine nitrogen atoms.

Suitable compounds for the hole transport matrix material of the doped hole transport layer and / or the common hole transport layer may be selected from the known hole transport matrices (HTMs), e.g. from triaryl amine compounds. HTMs for the doped hole transport material may be compounds comprising a conjugated system of delocalized electrons, wherein the conjugated system comprises lone electron pairs of at least two tertiary amine nitrogen atoms. Examples are N4,N4'-di(naphthalen-1-yl)-N4,N4'-diphenyl-[1,1'-biphenyl]-4,4'-diamine (HT1), and N4,N4, N4",N4"-tetra([1,1'-biphenyl]-4-yl)-[1,1':4',1"-terphenyl]-4,4"-diamine (HT4). The synthesis of terphenyldiamine HTMs is described e.g. in WO 2011/134458 A1, US 2012/223296 A1 or WO 2013/135237 A1; 1,3-phenylenediamine matrices are described e.g. in WO 2014/060526 A1. Many triaryl amine HTMs are commercially available.

The light emitting layer of the OLED display may comprise a plurality of sub-regions, each of the sub-regions being assigned to one of the pixels from the plurality of pixels. The light emitting layer of an individual pixel, corresponding to a sub-region of the emitting layer of the display, preferably does not touch light emitting layers of neighbor pixels. In the display manufacturing process, the organic layer comprising EMLs of individual pixels may be patterned by known methods, for example, by fine-metal masking (FMM), laser induced thermal imaging (LITI), and / or ink-jet printing (IJP) in either top emission, bottom emission or bottom emission micro cavity (see, for example, Chung et al. (2006), 70.1: Invited Paper: Large-Sized Full Color AMOLED TV: Advancements and Issues. SID Symposium Digest of Technical Papers, 37: 1958-1963, doi: 10.1889/1.2451418; Lee et al. (2009), 53.4: Development of 31-Inch Full-HD AMOLED TV Using LTPS-TFT and RGB FMM. SID Symposium Digest of Technical Papers, 40: 802-804. doi: 10.1889/1.3256911). A RGB layout may be provided.

For the plurality of OLED pixels, a common electron transport layer may be formed by the electron transport layers provided in the stack of organic layers of the plurality of OLED pixels.

The common electron transport layer may comprise an organic electron transport matrix (ETM) material. Further, the common electron transport layer may comprise one or more n-dopants-.Suitable compounds for the ETM contain aromatic or heteroaromatic structural moieties, as disclosed e.g. in documents EP 1970 371 A1 or WO 2013/079217 A1.

The cathode can be made of a metal or a metal alloy with a low work function. Transparent cathodes made of a TCO are also well-known in the art.

The stack of organic layers may be made of organic compounds having a molecular weight of less than 2000 g/mol. In an alternative embodiment, the organic compounds may have a molecular weight of less than 1000 g/mol.

### Description of embodiments

In the following, further embodiments will be described in further detail, by way of example, with reference to figures. In the figures show:

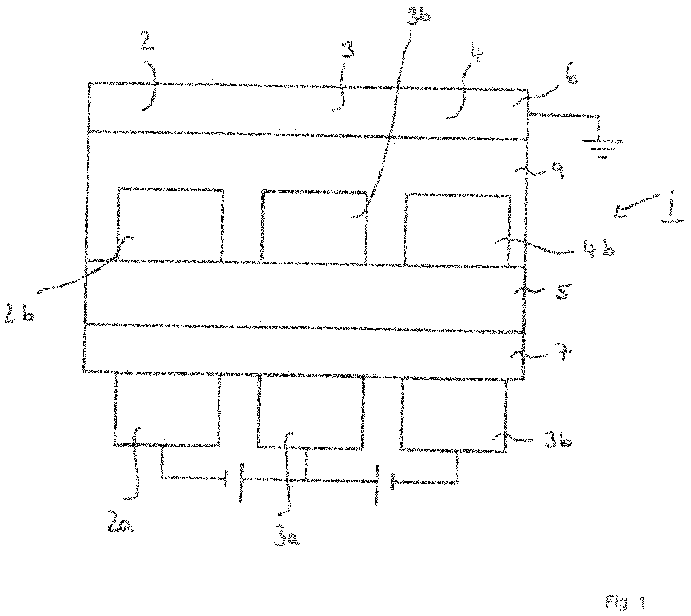

Fig. 1 a schematic representation of an active OLED display, the display having a plurality of OLED pixels,

Fig. 1 shows a schematic representation of an active OLED display 1 having a plurality of OLED pixels 2, 3, 4 provided in an OLED display 1. In the OLED display 1, each pixel 2, 3, 4 is provided with an anode 2a, 3a, 4a being connected to a driving circuit (not shown). Various equipment able to serve as a driving circuit for an active matrix display is known in the art. In one embodiment, the anodes 2a, 3a, 4a are made of a TCO, for example of ITO.

A cathode 6 is provided on top of an organic stack comprising an electrically doped hole transport layer (HTL) 7, an electron blocking layer (EBL) 5, a light emitting layer (EML) having sub-regions 2b, 3b, 4b assigned to the pixels 2, 3, 4 and being provided separately in an electron transport layer (ETL) 9. For example, the sub-regions 2b, 3b, 4b can provide an RGB combination for a color display (R - red, G - green, B - blue). By applying individual drive currents to the pixels 2, 3, 4 via the anodes 2a, 3a, 4a and the cathode 6, the display pixels 2, 3, 4 are operated independently.

### Synthesis examples

### LiPFPI

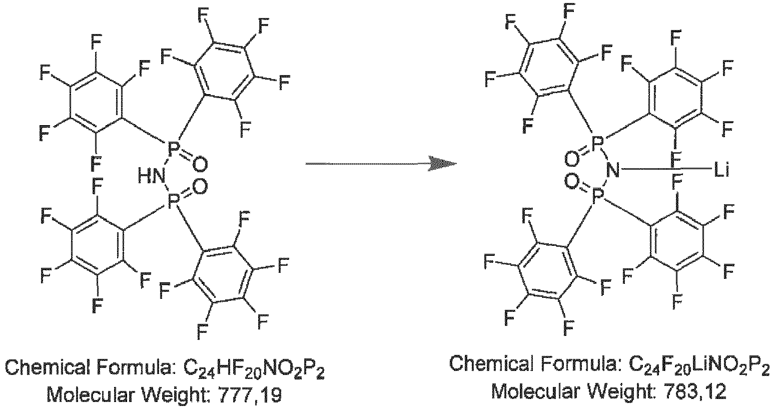

1.0 g (1.29 mmol) N-(bis(perfluorophenyl)phosphoryl)-P,P-bis(perfluorophenyl)phosphinic amide is dissolved in 20 mL dry toluene and cooled to 0 °C. 10 mg (12.9 mmol, 1.0 eq) lithium hydride are added. The mixture is heated to reflux for 2 h. After cooling to room temperature, the product is precipitated with 20 mL n-hexane, filtered off, washed with n-hexane (2× 10 mL). 0.62 g (61 %) product is obtained as a white solid after drying in high vacuum.

### ZnPFPI

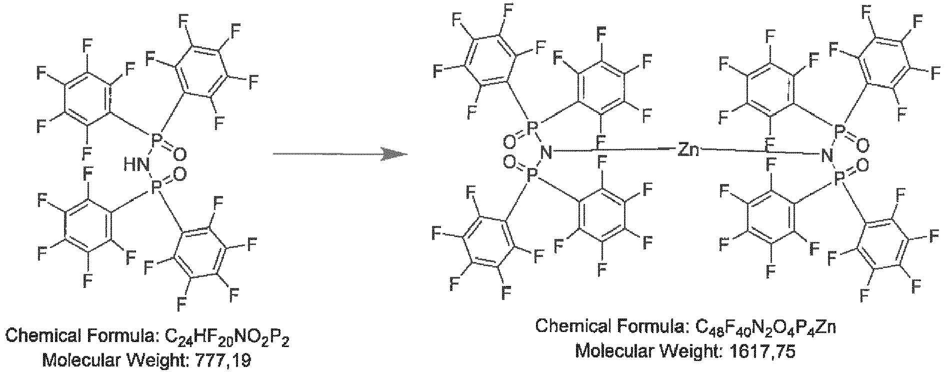

2.0 g (2.57 mmol) N-(bis(perfluorophenyl)phosphoryl)-P,P-bis(perfluorophenyl)phosphinic amide are dissolved in 50 mL dry toluene and cooled to 0°C. 1.6 mL (1.40 mmol, 0.55 eq) 0.9 M diethylzinc solution in hexane are added. The mixture is heated to reflux for 2 h. After cooling to room temperature, the product is precipitated with 50 mL n-hexane, filtered off, washed with n-hexane (2×10 mL). 1.05 g (51 %) product is obtained as a white solid after drying in high vacuum.

### Lithium bis((perfluorohexyl)sulfonyl)amide

### Step 1: lithium bis((perfluorohexyl)sulfonyl)amide

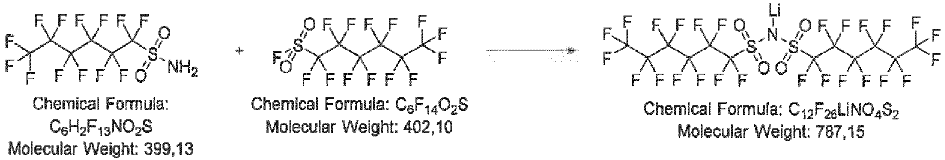

10.25 g (25.7 mmol) perfluorohexyl sulfonyl amide is dissolved in a dried Schlenk flask in 100 mL dry THF. 0.51 g (64.2 mmol, 2.5 eq) lithium hydride is added under Ar counter-flow to the ice-cooled solution. 10.33 g (25.7 mmol, 1.0 eq) perfluorohexylsulfonylfluoride is added dropwise to the resulting slurry. The mixture is heated to 60 °C for ca 18 h. The mixture is cooled to room temperature, filtered and the solvent is removed under reduced pressure. The residue is treated with 50 mL toluene and concentrated again. The crude product is slurry-washed with 50 mL hexane, the solid is filtered-off and dried in vacuum. The 13.49g (67 %) product is obtained as a pale yellow powder.

### Step 2: lithium bis((perfluorohexyl)sulfonyl)amine

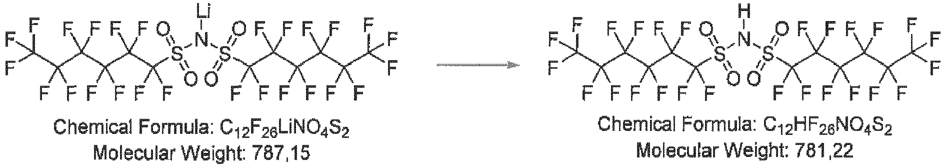

5.0 g (6.35 mmol) bis((perfluorohexyl)sulfonyl)amide is dissolved in 100 mL diethyl ether and 40 mL 25% aqueous sulfuric acid is cautiously added under ice cooling. The mixture is stirred vigorously for 15 min. The organic phase is separated, dried over magnesium sulfate, 5 mL toluene is added to avoid foaming and the solvent is evaporated under reduced pressure. The residue is purified using a bulb-to-bulb-distillation apparatus at a temperature about 140 °C and a pressure about 4 Pa. 3.70 g (75 %) product is obtained as a yellowish, waxy solid.

### Step 3: lithium bis((perfluorohexyl)sulfonyl)amide

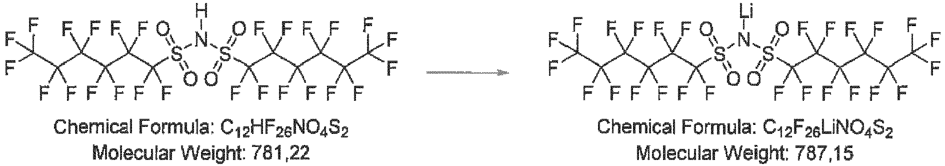

1.0 g (1.28 mmol) bis((perfluorohexyl)sulfonyl)amine is dissolved in 5 mL dry methyl-tert-butylether (MTBE). 12 mg (1.24 mmol, 1.0 eq) LiH ares added under Ar counter-flow. The reaction mixture is stirred overnight and the solvent subsequently removed under reduced pressure. The pale pink solid residue is dried at 60 °C in vacuum. 0.89 g (88%) product are obtained as an off-white solid.

Mass spectroscopy with electrospray ionization (MS-ESI) confirmed the expected synthesis outcome by the dominant presence of m/z 780 (anion C₁₂F₂₆NO₄S₂) in the intermediate bis((perfluorohexyl)sulfonyl)amine as well as in the Li salt.

### Zinc bis((perfluorohexyl)sulfonyl)amide

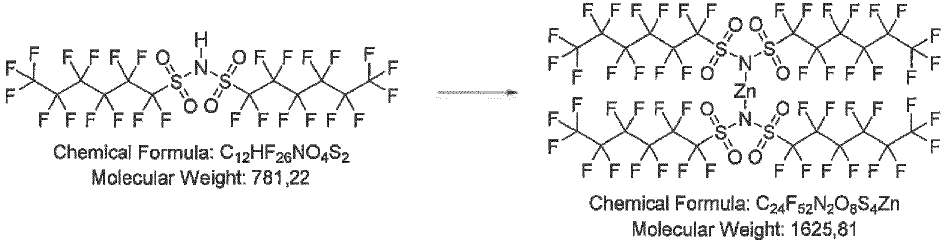

1.0 g (1.28 mmol) bis((perfluorohexyl)sulfonyl)amine is dissolved in 6 mL dry MTBE. 0.71 mL (0.64 mmol, 0.5 eq) diethyl zinc solution in hexane are added dropwise. The reaction mixture is stirred overnight and the solvent removed under reduced pressure. 0.794g (78 %) pale pink solid are obtained after drying at 60 °C in vacuum.

### Zinc bis((perfluoropropan-2-yl)sulfonyl)amide

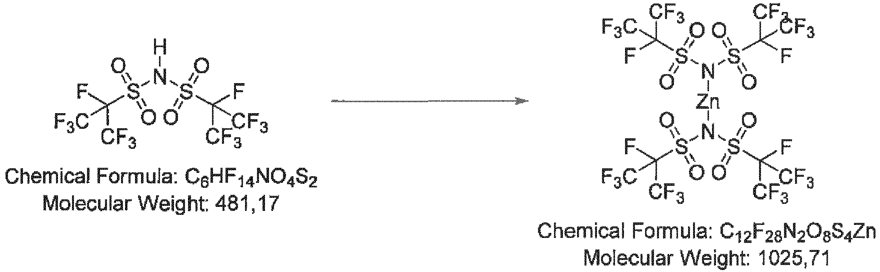

0.5 g (1.04 mmol ) bis((perfluoropropan-2-yl)sulfonyl)amine is dissolved in 10 mL dry MTBE, 0.47 mL (0.52 mmol, 0.5 eq) diethyl zinc solution in hexane are added dropwise and the mixture is stirred overnight at room temperature. 10 mL hexane are added and the resulting solid precipitate is filtered off and dried in high vacuum. 0.34 g (33 %) product are obtained as a white powder.

### Magnesium bis((perfluoropropan-2-yl)sulfony)amide

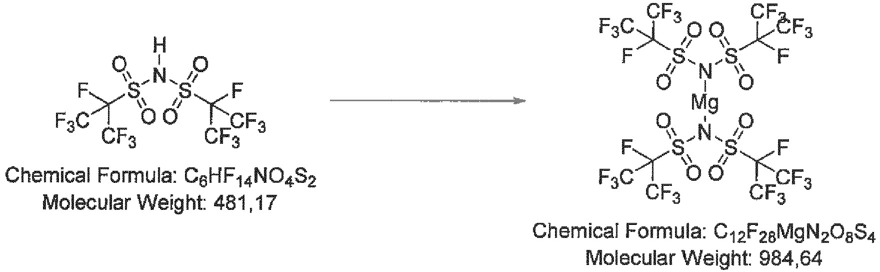

0.5g (1.04 mmol ) bis((perfluoropropan-2-yl)sulfonyl)amine is dissolved in 10 mL dry MTBE, 0.52 mL (0.52 mmol, 0.5 eq) dibutyl magnesium solution in heptane are added dropwise and the mixture is stirred overnight at room temperature. The solvent is removed under reduced pressure and the residue is dried in high vacuum. 0.38 g (74 %) product are obtained as a white powder.

### Lithium tris(4,5,6,7-tetrafluoro-3-(trifluoromethyl)-1H-indazol-1-yl)hydroborate (PB-1)

### Step 1: 4,5,6,7-tetrafluoro-3-(trifluoromethyl)-1H-indazole

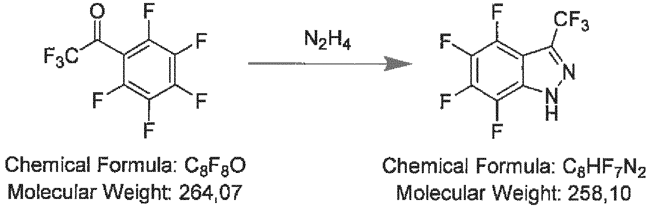

11.09 g (45.1 mmol) perfluoroacetophenone is dissolved in 100 mL toluene. The solution is cooled with an ice bath and 2.3 mL (2.37 g, 47.3 mmol, 1.05 eq) hydrazine-monohydrate is added dropwise. The mixture is heated to reflux for 3 days. After cooling to room temperature, the mixture is washed two times with 100 mL saturated aqueous sodium hydrogen carbonate solution and two times with 100 mL water, dried over magnesium sulfate and the solvent is removed under reduced pressure. The yellow, oily residue is distilled from bulb to bulb at a temperature about 140 °C and pressure about 12 Pa. The crude product is dissolved in hot hexane and the solution stored at -18 °C. The precipitated solid is filtered off and the slurry washed two times in 10 mL hexane. 5.0 g (43 %) product are obtained as a slightly yellow solid.
GCMS: confirms the expected M/z (mass/charge) ratio 258

### Step 2: lithium tris(4,5,6,7-tetrafluoro-3-(trifluoromethyl)-1H-indazol-1-yl)hydroborate

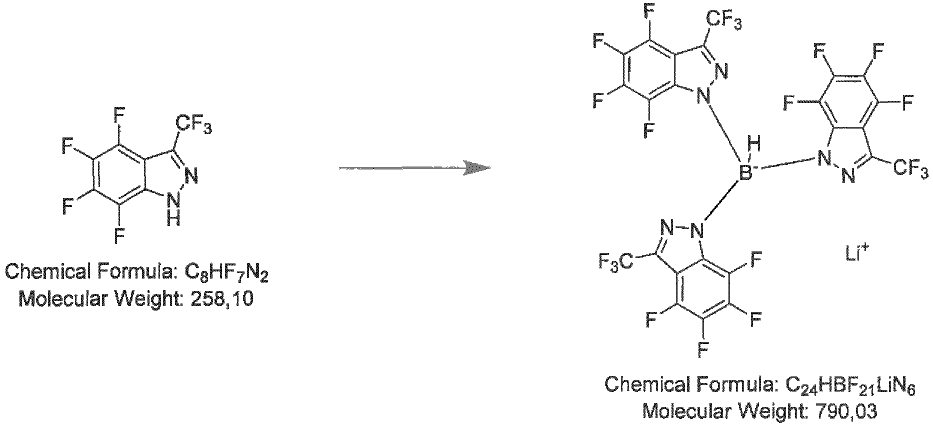

5.1 g (19.8 mmol) 4,5,6,7-tetrafluoro-3-(trifluoromethyl)-1H-indazole is added under Ar counter-flow to an out-baked Schlenk flask and treated with 3 mL toluene. Freshly pulverized lithium borohydride is added to the starting material. The mixture is heated to 100 °C, until hydrogen formed ceases (ca. 4h). After slight cooling, 15 mL hexane are added, the mixture is heated to reflux for 10 min and cooled to room temperature. The precipitated solid is filtered off, washed with 10 mL hot hexane and dried in high vacuum. 2.55g (49 %) product is obtained as an off-white solid.

### Lithium tris(3.5-bis(trifluoromethyl)-1H-pyrazol-1-yl)hydroborate (PB-2)

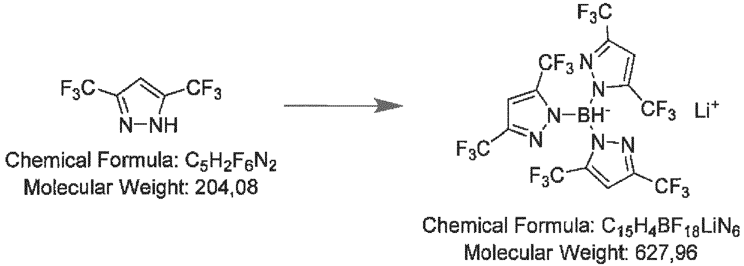

2.0 g ( 9.8 mmol, 5 eq) 3,5-bis(trifluoromethyl)pyrazole in a baked-out Schlenk flask is dissolved in 5 mL dry toluene. 43 mg (1.96 mmol, 1 eq) freshly pulverized lithium borohydride is added under Ar counter-flow and the mixture is heated to reflux for 3 days. The solvent and the excessive starting material are removed by distillation under reduced pressure and the residue is crystallized from n-chlorohexane. 0.25 g (20 %) product is obtained as a white solid.

### Lithium tris(4,5,6,7-tetrafluoro-3-(perfluorophenyl)-1H-indazol-1-yl)hydroborate (PB-3)

### Step 1: 4,5,6,7-tetrafluoro-3-(perfluorophenyl)-1H-indazole

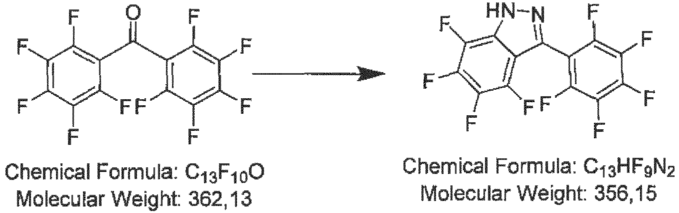

20.0 g (54.8 mmol) perfluorobenzophenone are dissolved in 200 mL toluene. 4.0 mL (4.11 g, 82.1 mmol, ca. 1.5 eq) hydrazine-monohydrate is added dropwise to the ice-cooled solution. 40 g sodium sulfate are added and the mixture is heated to reflux for 2 days. After cooling, 10 mL acetone are added to the reaction mixture and the resulting slurry is stirred for 1 h at room temperature. The solid is filtered off, thoroughly washed with 4×50 mL toluene, organic fractions are combined and washed two times with saturated aqueous sodium hydrogen carbonate. The solvent is removed under reduced pressure and the residue purified by column chromatography. 7.92 g (41 %) product are obtained as a pale yellow solid.
GC-MS: confirms the expected M/z (mass/charge) ratio 356

### Step 2: lithium tris(4,5,6,7-tetrafluoro-3-(perfluorophenyl)-1H-indazol-1-yl)hydroborate

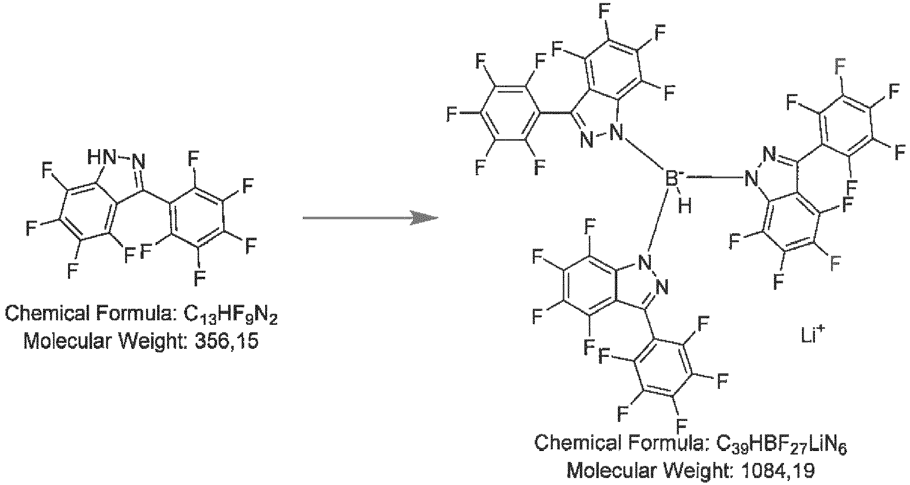

1.02 g (2.86 mmol, 3.0 eq) 4,5,6,7-tetrafluoro-3-(perfluorophenyl)-1H-indazole are dissolved in 5 mL chlorobenzene in a baked-out Schlenk flask. Freshly pulverized lithium borohydride (21 mg, 0.95 mmol, 1.0 eq) is added under Ar counter-flow. The mixture is heated to 150 °C for 2 days and cooled to room temperature. The solvent is removed under reduced pressure and the residue dried in high vacuum. The crude is further purified by drying in a bulb to bulb apparatus at a temperature about 150 °C and a pressure about12 Pa. 0.57 g (70 %) product is obtained as an off-white solid.

### Lithium tris(3-cyano-5,6-difluoro-1H-indazol-1-yl)hydroborate (PB-4)

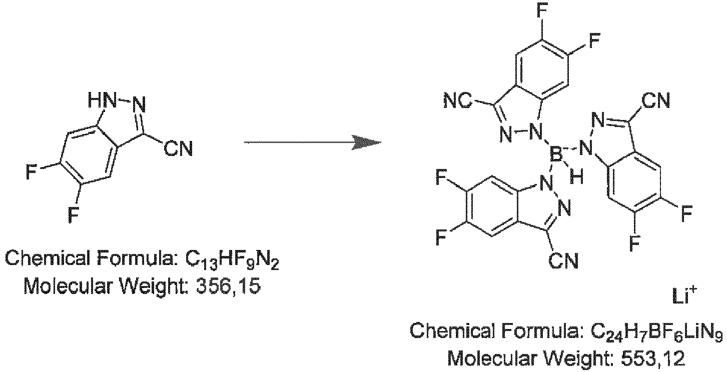

Freshly pulverized lithium borohydride (15 mg, 0.7 mmol, 1.0 eq) is placed in a baked-out pressure tube, 0.5 g (2.79 mmol, 4.0 eq) 5,6-difluoro-1H-indazole-3-carbonitrile are added under Ar counter-flow and washed down with 1 mL toluene. The pressure tube is closed and heated to a temperature about 160 °C for ca 21 h. After cooling to room temperature, the mixture is treated with 5 mL hexane in an ultra-sonic bath for ca 30 min. The precipitated solid is filtered off and washed with hexane (20 mL in total). After drying, 0.48 g yellowish solid is obtained.

### Zinc(II) tris(3,5-bis(trifluoromethyl)-1H-pyrazol-1-yl)hydroborate (PB-5)

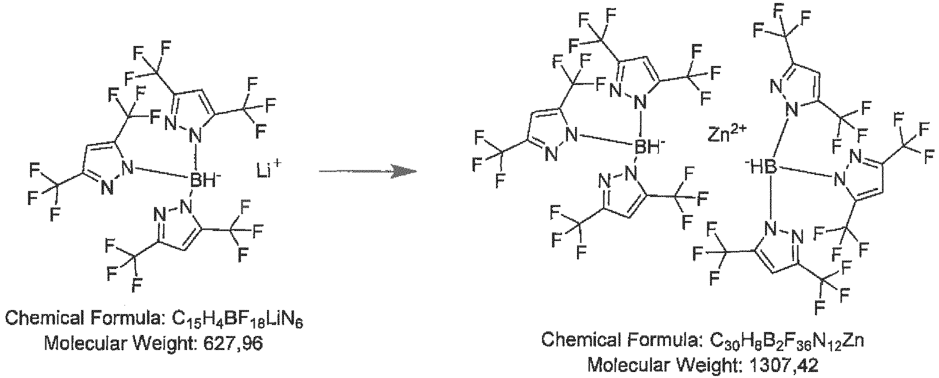

0.57g (0.91 mmol) lithium tris(3,5-bis(trifluoromethyl)-1H-pyrazol-1-yl)hydroborate is dissolved in 6 mL N,N-dimethyl formamide. An aqueous solution of 62 mg zinc dichloride in 1 mL water is added dropwise. 20 mL water is further added and the mixture is treated in an ultra-sonic bath for 2 h. The precipitate is filtered off and dried in high vacuum. 0.485 g (82 %) product is obtained as a white solid.

### Device examples

### Example 1 (tandem OLED, model for bottom emitting white OLED pixel)

On a glass substrate provided with an ITO anode having thickness 90 nm, there were subsequently deposited 10 nm hole injection layer made of F1 doped with 8 wt% PD-2; 140 nm thick undoped hole transport layer made of neat F1; 20 nm thick first emitting layer formed of ABH₁₁₃ doped with 3 wt% BD₂₀₀ (both supplied by SFC, Korea); 25 nm thick first electron transport layer made of neat F₂; 10 nm thick electron-generating part of the charge-generating layer (n-CGL) made of F₃ doped with 5 wt% Yb; 2 nm thick interlayer made of F₄; 30 nm thick hole-generating part of the charge-generating layer (p-CGL) made of PB-1; 10 nm thick second hole transport layer made of neat F1; 20 nm second emitting layer of the same thickness and composition as the first emitting layer; 25 nm thick first electron transport layer made of neat F2; 10 nm thick electron injection layer (EIL) made of F₃ doped with 5 wt% Yb; 100 nm Al cathode.

All layers were deposited by vacuum thermal evaporation (VTE).

At the current density 10 mA/cm₂, the operational voltage of the device 8 V was well comparable with the same device comprising a commercial state-of-art p-dopant instead of PB-1. Exact calibration of measuring equipment necessary for luminance/efficiency comparison was not made in this experiment..

### Example 2 (bottom emitting blue OLED pixel)

On the same glass substrate provided with an ITO anode as in the Example 1, following layers were subsequently deposited by VTE: 10 nm hole injection layer made of the compound PB-1; 120 nm thick HTL made of neat F1; 20 nm EML made of ABH113 doped with 3 wt% NUBD370 (both supplied by SFC, Korea), 36 nm EIL/ETL made of F2 doped with 50 wt% LiQ; 100 nm Al cathode.

Comparative device comprised the HIL made of the compound CN-HAT (CAS 105598-27-4) instead of PB-1.

The inventive device achieved current density 15 mA/cm² and external quantum efficiency (EQE) 5.4 % at an operational voltage 5.2 V, whereas the comparative device exhibited the same current density at a significantly higher voltage 5.4 V and with a significantly lower EQE 4.9 %.

**Table 1 auxiliary materials**

| Compound | Structure |
|---|---|
| F1 | 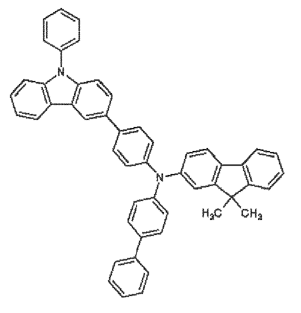 |
| (CAS 1242056-42-3) | |
| F2 | 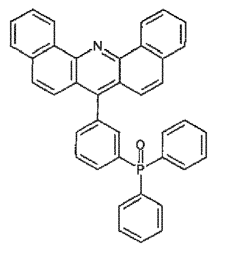 |
| (CAS 1440545-225-1) | |
| F3 | 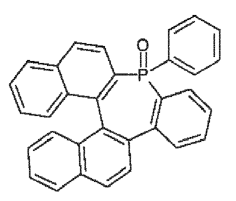 |
| (CAS 597578-38-6) | |
| F4 | 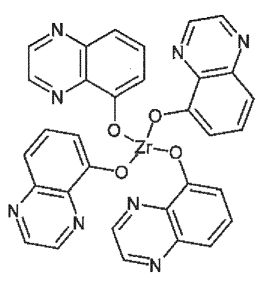 |
| (CAS 1207671-22-4) | |
| PD2 | 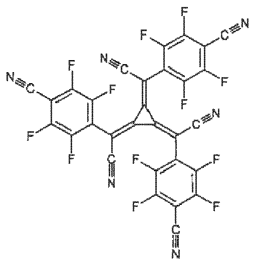 |
| 2,2',2"-(cyclopropane-1,2,3-triylidene)-tris[2-(4-cyanoperfluorophenyl)-acetonitrile] | |
| (CAS1224447-88-4) | |
| LiQ | 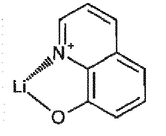 |
| 8-Hydroxyquinolato lithium | |
| (CAS 850918-68-2) | |
| CN-HAT | 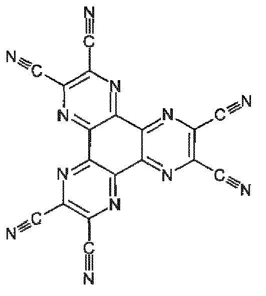 |
| (CAS 105598-27-4) | |

The features disclosed in the foregoing description and in the dependent claims may, both separately and in any combination thereof, be material for realizing the aspects of the disclosure made in the independent claims, in diverse forms thereof.

### Key symbols and abbreviations used throughout the application:

- CV: cyclic voltammetry
- DSC: differential scanning calorimentry
- EBL: electron blocking layer
- EIL: electron injecting layer
- EML: emitting layer
- eq.: equivalent
- ETL: electron transport layer
- ETM: electron transport matrix
- Fc: ferrocene
- Fc+: ferricenium
- HBL: hole blocking layer
- HIL: hole injecting layer
- HOMO: highest occupied molecular orbital
- HPLC: high performance liquid chromatography
- HTL: hole transport layer
- p-HTL: p-doped hole transport layer
- HTM: hole transport matrix
- ITO: indium tin oxide
- LUMO: lowest unoccupied molecular orbital
- mol%: molar percent
- NMR: nuclear magnetic resonance
- OLED: organic light emitting diode
- OPV: organic photovoltaics
- QE: quantum efficiency
- R_{f}: retardation factor in TLC
- RGB: red-green-blue
- TCO: transparent conductive oxide
- TFT: thin film transistor
- T_{g}: glass transition temperature
- TLC: thin layer chromatography
- wt%: weight percent

## Claims

1. Display device (1) comprising
- a plurality of OLED pixels comprising at least two OLED pixels (2, 3, 4), the OLED pixels (2, 3, 4) comprising an anode (2a, 3a, 4a), a cathode (6), and a stack of organic layers, wherein the stack of organic layers
- is arranged between and in contact with the cathode (6) and the anode (2a, 3a, 4a), and
- comprises a first electron transport layer (9), a first hole transport layer (7), and a first light emitting layer provided between the first hole transport layer (7) and the first electron transport layer (9), and
- a driving circuit configured to separately driving the pixels of the plurality of OLED pixels(2, 3, 4),
wherein, for the plurality of OLED pixels(2, 3, 4), the first hole transport layer (7) is provided in the stack of organic layers as a common hole transport layer shared by the plurality of OLED pixels (2, 3, 4), and the first hole transport layer comprises
(i) at least one first hole transport matrix compound consisting of covalently bound atoms and
(ii) at least one electrical p-dopant **characterized in that** the electrical p-dopant is selected from metal salts and from electrically neutral metal complexes comprising a metal cation and at least one anion and/or at least one anionic ligand, wherein the anion and/or the anionic ligand consists of at least 5 covalently bound atoms, wherein the anion and/or anionic ligand comprises at least one atom selected from B, C, N,
wherein the metal cation of the electrical p-dopant is selected from alkali metals; alkaline earth metals, Pb, Mn, Fe, Co, Ni, Zn, Cd; rare earth metals in oxidation state (II) or (III); Al, Ga, In; and from Sn, Ti, Zr, Hf, V, Nb, Ta, Cr, Mo and W in oxidation state (IV) or less.

2. Display device (1) according to claim 1, wherein the anion and/or the anionic ligand consists of at least 6, more preferably at least 7, even more preferably at least 8, most preferably at least 9 covalently bound atoms.

3. Display device (1) according to any of the preceding claims, wherein the anion and/or anionic ligand comprises at least two atoms selected from B, C and N which are bound to each other by a covalent bond.

4. Display device (1) according to any of the preceding claims, wherein the anion and/or anionic ligand comprises at least one peripheral atom selected from H, N, O, F, Cl, Br and I.

5. Display device (1) according to any of the preceding claims, wherein the anion and/or anionic ligand comprises at least one electron withdrawing group selected from halogenated alkyl, halogenated (hetero)aryl, halogenated (hetero)arylalkyl, halogenated alkylsulfonyl, halogenated (hetero)arylsulfonyl, halogenated (hetero)arylalkylsulfonyl, cyano.

6. Display device (1) according to claim 5, wherein the electron withdrawing group is a perhalogenated group.

7. Display device (1) according to claim 6, wherein the perhalogenated electron withdrawing group is a perfluorinated group.

8. Display device (1) according to any of the preceding claims, wherein the metal cation of the p-dopant is selected from Li(I), Na(I), K(I), Rb(I), Cs(I); Mg(II), Ca(II), Sr(II), Ba(II), Sn(II), Pb(II), Mn(II), Fe(II), Co(II), Ni(II), Zn(II), Cd(II), Al(III); rare earth metal in oxidation state (III), V(III), Nb(III), Ta(III), Cr(III), Mo(III), W(III) Ga(III), In(III) and from Ti(IV), Zr(IV), Hf(IV), Sn(IV).

9. Display device (1) according to any of the preceding claims, wherein in the p-dopant molecule, the atom of the anion and/or of the anionic ligand which is closest to the metal cation is a C or a N atom.

10. Display device (1) according to any of the preceding claims, wherein the acidity of the electrically neutral conjugated acid formed from the anion and/or anionic ligand by addition of one or more protons in 1,2-dichloroethane is higher than that of HCl, preferably higher than that of HBr, more preferably higher than that of HI, even more preferably higher than that of fluorosulfuric acid, and most preferably higher than that of perchloric acid, wherein the measurement of the acidity in 1,2-dichlorethane is performed in line with the disclosure of Journal of Organic Chemistry (2011), 76(2), 391-395.

11. Display device (1) according to any of the preceding claims, wherein the electrical p-dopant has energy level of its highest unoccupied molecular orbital computed by standard quantum chemical method and expressed in absolute vacuum scale at least 0.5 eV, preferably at least 0.6 eV, more preferably at least 0.8 eV, even more preferably at least 1.0 eV, most preferably at least 1.2 eV above the energy level of the highest occupied orbital of the first hole transport matrix compound computed by the standard quantum chemical method, wherein the standard quantum chemical method uses the software package TURBOMOLE using DFT functional B3LYP with the basis set def2-TZVP.

12. Display device (1) according to any of the preceding claims, wherein the first hole transport matrix compound is an organic compound, preferably an organic compound comprising a conjugated system of at least 6, more preferably at least 10 delocalized electrons; also preferably, the first hole transport matrix compound comprises at least one triaryl amine structural moiety, more preferably, the first hole transport matrix compound comprises at least two triaryl amine structural moieties.

13. Method for preparing the display device (1) according to any of the preceding claims, the method comprising at least one step wherein the first hole transport matrix compound and the electrical p-dopant are in mutual contact exposed to a temperature above 50 °C.

14. Method according to claim 13, wherein
(i) the p-dopant and the first hole transport matrix compound are dispersed in a solvent,
(ii) the dispersion is deposited on a substrate and
(iii) the solvent is evaporated at an elevated temperature.

15. Method according to claim 13, further comprising at least one step wherein the p-dopant is evaporated at a reduced pressure, preferably at a pressure below 1×10⁻² Pa and at a temperature above 50 °C, more preferably at a pressure below 5×10⁻² Pa and at a temperature above 80 °C, even more preferably at a pressure below 1×10⁻³ Pa and at a temperature above 120 °C, most preferably at a pressure below 5×10⁻⁴ Pa and at a temperature above 150 °C.

16. Method according to claim 13 to 15, wherein the p-dopant is used in form of a solid hydrate.

17. Method according to claim 15, wherein the p-dopant is used as an anhydrous solid comprising less than 0.10 wt % water, preferably less than 0.05 wt % water.

18. Compound having formula (I) 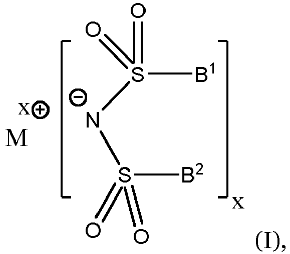 wherein
M^{x⊕} is a x-valent cation of a metal selected from alkali metals, alkaline earth metals, rare earth metals and Al, Ga, In, Sn, Ti, Zr, Hf, V, Nb, Ta, Cr, Mo, W, Mn, Fe, Co, Ni, Zn and Cd;
x is 1 for M selected from alkali metals; 2 for M selected from alkaline earth metals, Mn, Fe, Co, Ni, Zn and Cd; 2 or 3 for M selected from rare earth metals; 3 for Al, Ga, In; 2, 3 or 4 for Ti, Zr, Hf, V, Nb, Ta, Cr, Mo, W; and 2 or 4 for Sn;
B¹and B² is independently selected from perhalogenated C₃ to C₂₀ alkyl, C₃ to C₂₀ cycloalkyl or C₃ to C₂₀ arylalkyl;
with the proviso that the compound having formula (I), wherein
a) M is selected from alkali metals, Mg, Ca and Zn and B¹ and B² are independently selected from perfluorinated straight-chain primary alkyl, or
b) M is Li and B¹ and B² is perfluorinated isopropyl,
is excluded.

19. Compound according to claim 18, wherein M is selected from Mg(II), Mn(II) and Zn(II).

20. Compound according to claim 18 or 19 in a solid form, preferably in a solid form comprising less than 0.10 wt % water, more preferably in a solid form comprising less than 0.05 wt % water, most preferably in a solid crystalline form comprising less than 0.05 wt % water.

21. Compound according to claim 18 or 19 in form of a solid crystalline hydrate, preferably in form of a solid crystalline hydrate which has water content in the range
(i) from 30.33 to 36.33 mol%, preferably from 31.00 to 35.66 mol%, more preferably from 31.00 to 35.66 mol%, even more preferably from 31.66 to 35.00 mol%, even more preferably from 32.33 to 34.33 mol%, most preferably from 33.00 to 33.66 mol%; or
(ii) from 18.20 to 21.80 mol%, preferably from 18.60 to 21.40 mol%, more preferably from 19.00 to 21.00 mol%, even more preferably from 19.40 to 20.60 mol%, most preferably from 19.80 to 20.20 mol%.

## Patentansprüche

1. Anzeigevorrichtung (1), umfassend
- eine Vielzahl von OLED-Pixeln, die mindestens zwei OLED-Pixel (2, 3, 4) aufweisen, wobei die OLED-Pixel (2, 3, 4) eine Anode (2a, 3a, 4a), eine Kathode (6) und einen Stapel von organischen Schichten umfassen, wobei der Stapel von organischen Schichten
- zwischen der Kathode (6) und der Anode (2a, 3a, 4a) angeordnet ist und mit diesen in Kontakt steht, und
- eine erste Elektronentransportschicht (9), eine erste Lochtransportschicht (7) und eine erste lichtemittierende Schicht, die zwischen der ersten Lochtransportschicht (7) und der ersten Elektronentransportschicht (9) vorgesehen ist, aufweist, und
- eine Ansteuerungsschaltung, die so konfiguriert ist, dass sie die Pixel aus der Vielzahl der OLED-Pixel (2, 3, 4) separat ansteuert,
wobei für die Vielzahl von OLED-Pixeln (2, 3, 4) die erste Lochtransportschicht (7) in dem Stapel von organischen Schichten als eine gemeinsame Lochtransportschicht vorgesehen ist, die von der Vielzahl von OLED-Pixeln (2, 3, 4) gemeinsam genutzt wird, und die erste Lochtransportschicht umfasst
(i) mindestens eine erste Lochtransportmatrixverbindung, die aus kovalent gebundenen Atomen besteht, und
(ii) mindestens ein elektrisches p-Dotierungsmittel, **dadurch gekennzeichnet, dass** das elektrische p-Dotierungsmittel aus Metallsalzen und aus elektrisch neutralen Metallkomplexen ausgewählt ist, die ein Metallkation und mindestens ein Anion und/oder mindestens einen anionischen Liganden umfassen, wobei das Anion und/oder der anionische Ligand aus mindestens 5 kovalent gebundenen Atomen besteht, wobei das Anion und/oder der anionische Ligand mindestens ein Atom, ausgewählt aus B, C, N, umfasst,
wobei das Metallkation des elektrischen p-Dotierungsmittels ausgewählt ist aus Alkalimetallen; Erdalkalimetallen, Pb, Mn, Fe, Co, Ni, Zn, Cd; Seltenerdmetallen in der Oxidationsstufe (II) oder (III); Al, Ga, In; und aus Sn, Ti, Zr, Hf, V, Nb, Ta, Cr, Mo und W in der Oxidationsstufe (IV) oder weniger.

2. Anzeigevorrichtung (1) nach Anspruch 1, wobei das Anion und/oder der anionische Ligand aus mindestens 6, stärker bevorzugt mindestens 7, noch stärker bevorzugt mindestens 8, am meisten bevorzugt mindestens 9 kovalent gebundenen Atomen besteht.

3. Anzeigevorrichtung (1) nach einem der vorhergehenden Ansprüche, wobei das Anion und/oder der anionische Ligand mindestens zwei Atome, ausgewählt aus B, C und N, umfasst, die durch eine kovalente Bindung aneinander gebunden sind.

4. Anzeigevorrichtung (1) nach einem der vorhergehenden Ansprüche, wobei das Anion und/oder der anionische Ligand mindestens ein peripheres Atom, ausgewählt aus H, N, O, F, Cl, Br und I, umfasst.

5. Anzeigevorrichtung (1) nach einem der vorhergehenden Ansprüche, wobei das Anion und/oder der anionische Ligand mindestens eine elektronenentziehende Gruppe umfasst, die ausgewählt ist aus halogeniertem Alkyl, halogeniertem (Hetero)Aryl, halogeniertem (Hetero)Arylalkyl, halogeniertem Alkylsulfonyl, halogeniertem (Hetero)Arylsulfonyl, halogeniertem (Hetero)Arylalkylsulfonyl, Cyano.

6. Anzeigevorrichtung (1) nach Anspruch 5, wobei die elektronenentziehende Gruppe eine perhalogenierte Gruppe ist.

7. Anzeigevorrichtung (1) nach Anspruch 6, wobei die perhalogenierte elektronenentziehende Gruppe eine perfluorierte Gruppe ist.

8. Anzeigevorrichtung (1) nach einem der vorhergehenden Ansprüche, wobei das Metallkation des p-Dotierungsmittels ausgewählt ist aus Li(I), Na(I), K(I), Rb(I), Cs(I); Mg(II), Ca(II), Sr(II), Ba(II), Sn(II), Pb(II), Mn(II), Fe(II), C0(H), Ni(II), Zn(II), Cd(II), Al(III); Seltene Erden im Oxidationszustand (III), V(III), Nb(III), Ta(III), Cr(III), Mo(III), W(III) Ga(III), In(III) und aus Ti(IV), Zr(IV), Hf(IV), Sn(IV).

9. Anzeigevorrichtung (1) nach einem der vorhergehenden Ansprüche, wobei im p-Dotierungsmittelmolekül das Atom des Anions und/oder des anionischen Liganden, das dem Metallkation am nächsten ist, ein C- oder ein N-Atom ist.

10. Anzeigevorrichtung (1) nach einem der vorhergehenden Ansprüche, **dadurch gekennzeichnet, dass** die Azidität der aus dem Anion und/oder dem anionischen Liganden durch Zugabe eines oder mehrerer Protonen in 1,2-Dichlorethan gebildeten elektrisch neutralen konjugierten Säure höher ist als die von HCl, vorzugsweise höher als die von HBr, noch bevorzugter höher als die von Hl, noch bevorzugter höher als die von Fluorschwefelsäure, und am meisten bevorzugt höher als die von Perchlorsäure, wobei die Messung der Azidität in 1,2-Dichlorethan gemäß der Offenlegung in Journal of Organic Chemistry (2011), 76(2), 391-395, durchgeführt wird.

11. Anzeigevorrichtung (1) nach einem der vorhergehenden Ansprüche, wobei das elektrische p-Dotierungsmittel ein Energieniveau seines höchsten unbesetzten Molekülorbitals aufweist, das nach einem quantenchemischen Standardverfahren berechnet und im absoluten Vakuummaßstab ausgedrückt wird, das mindestens 0,5 eV, vorzugsweise mindestens 0,6 eV, noch bevorzugter mindestens 0,8 eV, noch bevorzugter mindestens 1,0 eV, am meisten bevorzugt mindestens 1,2 eV über dem Energieniveau des höchsten besetzten Orbitals der ersten Lochtransportmatrixverbindung liegt, das nach dem quantenchemischen Standardverfahren berechnet wird, wobei die quantenchemische Standardmethode das Softwarepaket TURBOMOLE unter Verwendung der DFI'-Funktionsgruppe B3LYP mit dem Basissatz def2-TZVP verwendet.

12. Anzeigevorrichtung (1) nach einem der vorhergehenden Ansprüche, wobei die erste Lochtransportmatrixverbindung eine organische Verbindung ist, vorzugsweise eine organische Verbindung, die ein konjugiertes System von mindestens 6, noch bevorzugter mindestens 10 delokalisierten Elektronen umfasst; ebenfalls vorzugsweise umfasst die erste Lochtransportmatrixverbindung mindestens eine Triarylamin-Struktureinheit, noch bevorzugter umfasst die erste Lochtransportmatrixverbindung mindestens zwei Triarylamin-Struktureinheiten.

13. Verfahren zur Herstellung der Anzeigevorrichtung (1) nach einem der vorhergehenden Ansprüche, wobei das Verfahren mindestens einen Schritt umfasst, bei dem die erste Lochtransportmatrixverbindung und das elektrische p-Dotierungsmittel in gegenseitigem Kontakt stehen und einer Temperatur über 50 °C ausgesetzt sind.

14. Verfahren nach Anspruch 13, wobei
(i) das p-Dotierungsmittel und die erste Lochtransportmatrixverbindung in einem Lösungsmittel dispergiert sind,
(ii) die Dispersion auf einem Substrat abgeschieden wird, und
(iii) das Lösungsmittel bei erhöhter Temperatur verdampft wird.

15. Verfahren nach Anspruch 13, das ferner mindestens einen Schritt umfasst, bei dem das p-Dotierungsmittel bei einem reduzierten Druck verdampft wird, vorzugsweise bei einem Druck unter 1×10⁻² Pa und bei einer Temperatur über 50 °C, noch bevorzugter bei einem Druck unter 5×10⁻² Pa und bei einer Temperatur über 80 °C, noch bevorzugter bei einem Druck unter 1×10⁻³ Pa und bei einer Temperatur über 120 °C, am meisten bevorzugt bei einem Druck unter 5×10⁻⁴ Pa und bei einer Temperatur über 150 °C.

16. Verfahren nach einem der Ansprüche 13 bis 15, wobei das p-Dotierungsmittel in Form eines festen Hydrats verwendet wird.

17. Verfahren nach Anspruch 15, wobei das p-Dotierungsmittel als wasserfreier Feststoff mit weniger als 0,10 Gew.-% Wasser, vorzugsweise weniger als 0,05 Gew.-% Wasser, verwendet wird.

18. Verbindung mit der Formel (1) 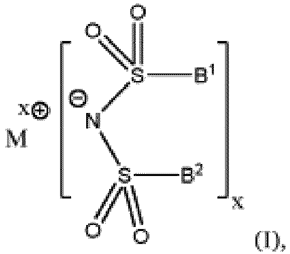 wobei
M^{x⊕} ein x-wertiges Kation eines Metalls, ausgewählt aus Alkalimetallen, Erdalkalimetallen, Seltenerdmetallen und Al, Ga, In, Sn, Ti, Zr, Hf, V, Nb, Ta, Cr, Mo, W, Mn, Fe, Co, Ni, Zn und Cd, ist;
x 1 für M ist, ausgewählt aus Alkalimetallen; 2 für M ist, ausgewählt aus Erdalkalimetallen, Mn, Fe, Co, Ni, Zn und Cd; 2 oder 3 für M ist, ausgewählt aus Seltenerdmetallen; 3 ist für Al, Ga, In; 2, 3 oder 4 ist für Ti, Zr, Hf, V, Nb, Ta, Cr, Mo, W; und 2 oder 4 für Sn ist;
B¹ und B² sind unabhängig voneinander ausgewählt aus perhalogeniertem C₃- bis C₂₀-Alkyl, C₃- bis C₂₀-Cycloalkyl oder C₃- bis C₂₀-Arylalkyl;
mit der Maßgabe, dass die Verbindung mit der Formel (I), worin
a) M ausgewählt ist aus Alkalimetallen, Mg, Ca und Zn, und B¹ und B² unabhängig voneinander ausgewählt sind aus perfluoriertem geradkettigem primärem Alkyl, oder
b) M Li ist und B¹ und B² perfluoriertes Isopropyl sind, ausgeschlossen ist.

19. Verbindung nach Anspruch 18, wobei M ausgewählt ist aus Mg(II), Mn(II) und Zn(II).

20. Verbindung nach Anspruch 18 oder 19 in einer festen Form, vorzugsweise in einer festen Form, die weniger als 0,10 Gew.-% Wasser enthält, noch bevorzugter in einer festen Form, die weniger als 0,05 Gew.-% Wasser enthält, am meisten bevorzugt in einer festen kristallinen Form, die weniger als 0,05 Gew.-% Wasser enthält.

21. Verbindung nach Anspruch 18 oder 19 in Form eines festen kristallinen Hydrats, vorzugsweise in Form eines festen kristallinen Hydrats, das einen Wassergehalt aufweist, der im Bereich von
(i) 30,33 bis 36,33 Mol-%, vorzugsweise 31,00 bis 35,66 Mol-%, noch bevorzugter 31,00 bis 35,66 Mol-%, noch bevorzugter 31,66 bis 35,00 Mol-%, noch bevorzugter 32,33 bis 34,33 Mol-%, am meisten bevorzugt 33,00 bis 33,66 Mol-% liegt; oder
(ii) 18,20 bis 21,80 Mol-%, vorzugsweise 18,60 bis 21,40 Mol-%, noch bevorzugter 19,00 bis 21,00 Mol-%, noch bevorzugter 19,40 bis 20,60 Mol-%, am meisten bevorzugt 19,80 bis 20,20 Mol-% liegt.

## Revendications

1. Dispositif d'affichage (1) comprenant
- une pluralité de pixels OLED comprenant au moins deux pixels OLED (2, 3, 4), les pixels OLED (2, 3, 4) comprenant une anode (2a, 3a, 4a), une cathode (6) et un empilement de couches organiques, dans lequel l'empilement de couches organiques
- est disposé entre la cathode (6) et l'anode (2a, 3a, 4a) et est en contact avec elles, et
- comprend une première couche de transport d'électrons (9), une première couche de transport de trous (7) et une première couche émettrice de lumière disposée entre la première couche de transport de trous (7) et la première couche de transport d'électrons (9), et
- un circuit de commande configuré pour commander séparément les pixels de la pluralité de pixels OLED (2, 3, 4),
dans lequel, pour la pluralité de pixels OLED (2, 3, 4), la première couche de transport de trous (7) est fournie dans la pile de couches organiques en tant que couche de transport de trous commune partagée par la pluralité de pixels OLED (2, 3, 4), et la première couche de transport de trous comprend
(i) au moins un composé matriciel de transport de trous constitué d'atomes liés de manière covalente et
(ii) au moins un dopant électrique p **caractérisé en ce que** le dopant électrique p est choisi parmi les sels métalliques et parmi les complexes métalliques électriquement neutres comprenant un cation métallique et au moins un anion et/ou au moins un ligand anionique, dans lequel l'anion et/ou le ligand anionique est constitué d'au moins 5 atomes liés de manière covalente,
dans lequel l'anion et/ou le ligand anionique comprend au moins un atome choisi parmi les atomes B, C, N,
dans lequel le cation métallique du dopant électrique p est choisi parmi les métaux alcalins ; les métaux alcalino-terreux, Pb, Mn, Fe, Co, Ni, Zn, Cd ; les métaux des terres rares à l'état d'oxydation (II) ou (III) ; Al, Ga, In ; et parmi Sn, Ti, Zr, Hf, V, Nb, Ta, Cr, Mo et W à l'état d'oxydation (IV) ou moins.

2. Dispositif d'affichage (1) selon la revendication 1, dans lequel l'anion et/ou le ligand anionique est constitué d'au moins 6, plus préférablement d'au moins 7, encore plus préférablement d'au moins 8, le plus préférablement d'au moins 9 atomes liés de manière covalente.

3. Dispositif d'affichage (1) selon l'une quelconque des revendications précédentes, dans lequel l'anion et/ou le ligand anionique comprend au moins deux atomes choisis parmi les atomes B, C et N qui sont liés entre eux par une liaison covalente.

4. Dispositif d'affichage (1) selon l'une quelconque des revendications précédentes, dans lequel l'anion et/ou le ligand anionique comprend au moins un atome périphérique choisi parmi H, N, O, F, Cl, Br et I.

5. Dispositif d'affichage (1) selon l'une quelconque des revendications précédentes, dans lequel l'anion et/ou le ligand anionique comprend au moins un groupe électroattracteur choisi parmi un alkyle halogéné, un (hétéro)aryle halogéné, un (hétéro)arylalkyle halogéné, un alkylsulfonyle halogéné, un (hétéro)arylsulfonyle halogéné, un (hétéro)arylalkylsulfonyle halogéné, un cyano.

6. Dispositif d'affichage (1) selon la revendication 5, dans lequel le groupe électroattracteur est un groupe perhalogéné.

7. Dispositif d'affichage (1) selon la revendication 6, dans lequel le groupe électroattracteur perhalogéné est un groupe perfluoré.

8. Dispositif d'affichage (1) selon l'une quelconque des revendications précédentes, dans lequel le cation métallique du dopant p est choisi parmi Li(I), Na(I), K(I), Rb(I), Cs(I) ; Mg(II), Ca(II), Sr(II), Ba(II), Sn(II), Ph(II), Mn(II), Fe(II), Co(ll), Ni(II), Zn(II), Cd(II), Al(III) ; un métal des terres rares à l'état d'oxydation (III), V(III), Nb(III), Ta(III), Cr(III), Mo(III), W(III) Ga(III), In(III) et parmi Ti(IV), Zr(IV), Hf(IV), Sn(IV).

9. Dispositif d'affichage (1) selon quelconque des revendications précédentes, dans lequel dans la molécule de dopant p, l'atome de l'anion et/ou du ligand anionique qui est le plus proche du cation métallique est un atome C ou un atome N.

10. Dispositif d'affichage (1) selon l'une quelconque des revendications précédentes, dans lequel l'acidité de l'acide conjugué électriquement neutre formé à partir de l'anion et/ou du ligand anionique par addition d'un ou de plusieurs protons dans le 1,2-dichloroéthane est supérieure à celle de HCl, de préférence supérieure à celle de HBr, plus préférablement supérieure à celle de Hl, encore plus préférablement supérieure à celle de l'acide fluorosulfurique, et plus préférablement supérieure à celle de l'acide perchlorique, dans lequel la mesure de l'acidité dans le 1,2-dichloroéthane est effectuée conformément à la publication dans le Journal of Organic Chemistry (2011), 76(2), 391-395.

11. Dispositif d'affichage (1) selon l'une quelconque des revendications précédentes, dans lequel le dopant électrique p possède un niveau d'énergie de son orbitale moléculaire inoccupée la plus élevée calculé au moyen d'un procédé chimique quantique standard et exprimé dans l'échelle du vide absolu d'au moins 0,5 eV, de préférence d'au moins 0,6 eV, plus préférablement d'au moins 0,8 eV, encore plus préférablement d'au moins 1,0 eV, le plus préférablement d'au moins 1,2 eV au-dessus du niveau d'énergie de l'orbitale occupée la plus élevée du premier composé de la matrice de transport de trou calculé au moyen du procédé chimique quantique standard, dans lequel le procédé chimique quantique standard utilise le progiciel TURBOMOLE utilisant la fonctionnelle DFT B3LYP avec l'ensemble de base def2-TZVP.

12. Dispositif d'affichage (1) selon l'une quelconque des revendications précédentes, dans lequel le premier composé de matrice de transport de trous est un composé organique, de préférence un composé organique comprenant un système conjugué d'au moins 6, plus préférablement d'au moins 10 électrons délocalisés ; de préférence également, le premier composé de matrice de transport de trous comprend au moins un groupement structurel triaryle amine, plus préférablement, le premier composé de matrice de transport de trous comprend au moins deux groupements structurels triaryle amine.

13. Procédé de préparation du dispositif d'affichage (1) selon l'une quelconque des revendications précédentes, le procédé comprenant au moins une étape dans laquelle le composé matriciel de transport des premiers trous et le dopant électrique p sont en contact mutuel et exposés à une température supérieure à 50 °C.

14. Procédé selon la revendication 13, dans lequel
(i) le dopant p et le premier composé matriciel de transport de trou sont dispersés dans un solvant,
(ii) la dispersion est déposée sur un substrat et
(iii) le solvant est évaporé à une température élevée.

15. Procédé selon la revendication 13, comprenant en outre au moins une étape dans laquelle le dopant p est évaporé à une pression réduite, de préférence à une pression inférieure à 1×10⁻² Pa et à une température supérieure à 50 °C, plus préférablement à une pression inférieure à 5×10⁻² Pa et à une température supérieure à 80 °C, encore plus préférablement à une pression inférieure à 1× 10⁻³ Pa et à une température supérieure à 120 °C, le plus préférablement à une pression inférieure à 5×10⁻⁴ Pa et à une température supérieure à 150 °C.

16. Procédé selon la revendication 13 à 15, dans lequel le dopant p est utilisé sous forme d'hydrate solide.

17. Procédé selon la revendication 15, dans lequel le dopant p est utilisé sous forme de solide anhydre comprenant moins de 0,10 % en poids d'eau, de préférence moins de 0,05 % en poids d'eau.

18. Composé ayant la formule (1) 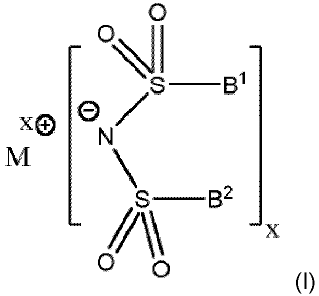 dans laquelle
M^{x ⊕} est un cation x-valent d'un métal choisi parmi les métaux alcalins, les métaux alcalino-terreux, les métaux des terres rares et Al, Ga, In, Sn, Ti, Zr, Hf, V, Nb, Ta, Cr, Mo, W, Mn, Fe, Co, Ni, Zn et Cd ;
x vaut 1 pour M choisi parmi les métaux alcalins ; vaut 2 pour M choisi parmi les métaux alcalino-terreux, Mn, Fe, Co, Ni, Zn et Cd ; vaut 2 ou 3 pour M choisi parmi les métaux des terres rares ; vaut 3 pour Al, Ga, In ; vaut 2, 3 ou 4 pour Ti, Zr, Hf, V, Nb, Ta, Cr, Mo, W ; et vaut 2 ou 4 pour Sn ;
B¹ et B² sont indépendamment choisis parmi les alkyles perhalogénés en C₃ à C₂₀, les cycloalkyles en C₃ à C₂₀ ou les arylalkyles en C₃ à C₂₀ ;
à condition que le composé ayant la formule (I), dans laquelle
a) M est choisi parmi les métaux alcalins, Mg, Ca et Zn et B¹ et B² sont indépendamment choisis parmi les alkyles primaires perfluorés à chaîne linéaire, ou
b) M représente Li et B¹ et B² représentent des isopropyles perfluorés,
est exclu.

19. Composé selon la revendication 18, dans lequel M est choisi parmi Mg(II), Mn(II) et Zn(II).

20. Composé selon la revendication 18 ou la revendication 19 sous forme solide, de préférence sous forme solide comprenant moins de 0,10 % en poids d'eau, plus préférablement sous forme solide comprenant moins de 0,05 % en poids d'eau, le plus préférablement sous forme solide cristalline comprenant moins de 0,05 % en poids d'eau.

21. Composé selon la revendication 18 ou la revendication 19 sous forme d'hydrate cristallin solide, de préférence sous forme d'hydrate cristallin solide dont la teneur en eau est comprise
(i) entre 30,33 et 36,33 % en moles, de préférence entre 31,00 et 35,66 % en moles, plus préférablement entre 31,00 et 35,66 % en moles, encore plus préférablement entre 31,66 et 35,00 % en moles, encore plus préférablement entre 32,33 et 34,33 % en moles, le plus préférablement entre 33,00 et 33,66 % en moles ; ou
(ii) entre 18,20 et 21,80 % en moles, de préférence entre 18,60 et 21,40 % en moles, plus préférablement entre 19,00 et 21,00 % en moles, encore plus préférablement entre 19,40 et 20,60 % en moles, le plus préférablement entre 19,80 et 20,20 % en moles.
